# EUROPEAN PATENT SPECIFICATION

(11) **EP 2 786 181 B1**
(45) Date of publication and mention of the grant of the patent: **21.11.2018**
(21) Application number: 12798670.1
(22) Date of filing: 29.11.2012
(51) Int. Cl.: G02B 3/00, H01L 33/58

(54) **LENS AND ILLUMINATING DEVICE**
LINSE UND BELEUCHTUNGSVORRICHTUNG
LENTILLE ET DISPOSITIF D'ÉCLAIRAGE

(30) Priority: 02.12.2011 CN 201110397957
(43) Date of publication of application: 08.10.2014
(73) Proprietor: OSRAM GmbH, 80807 München (DE)
(72) Inventor: MING, Yusheng, Shenzhen Guangdong 518053 (CN); CHEN, Peng, Shenzhen Guangdong 518053 (CN); LI, Aiai, Shenzhen Guangdong 518053 (CN); CHEN, Xiaomian, Shenzhen Guangdong 518053 (CN)
(86) International application number: PCT/EP2012/073962
(87) International publication number: WO 2013/079592

(56) References cited:
- WO-A1-2010/146902
- US-A1- 2006 291 185
- US-A1- 2010 308 359
- US-B1- 6 870 681

## Description

### Technical Field

The present invention relates to a lens and an illuminating device with the lens.

### Background Art

With the development of the LED illuminating technology, more LED illuminating devices are used as light sources in various environments. The luminance of a real light spot formed by light from an LED chip is not uniform due to a manufacturing tolerance of the LED chip. Sometimes, the illuminance is not uniform and the color is not uniform, either. In order to solve the above problems and obtain an illuminating effect as good as is possible, a lens is usually needed to be installed over the LED chip to adjust light from the LED chip. In the prior art, an emergent surface of the lens is structured, that is to say, many convexes or concaves are randomly distributed on the emergent surface for forming a diffuse surface that adjusts the light from the LED chip. Another solution is to directly equip a diffuse screen over the top of the lens so as to adjust the light from the LED chip. However, it is hard to anticipate or simulate the light distribution when the light is adjusted by the above lens and diffuse screen. The light distribution of the light adjusted by the lens and diffuse screen above is random.

An earlier patent application US 2010/0308359 A1 discloses a substrate comprised in a solid state light source. However, the substrate does not have a surface which comprises a spherical region in the center and a conical region at both US 6,870,681 B1 discloses a microlens array wherein each microlens comprises a cavity. WO 2010/146902 A1 discloses an individual microlens comprising a cavity.

### Summary of the Invention

In order to solve the above problems, the present invention provides a lens for an illuminating device. Light emerging from the lens can be diffused on an object to be illuminated and realize an expected light distribution effect. In addition, the present invention further relates to an illuminating device with the lens.

The first object of the present invention is accomplished via a lens. The lens comprises a base and a microlens array arranged on the base, wherein the microlens array comprises a plurality of microlenses, respective microlens has a light incident surface facing a light source of the illuminating device and a light emergent surface facing away from the light source, characterized in that the light incident surface is a first curved surface that defines a cavity opening to the light source, and the light emergent surface is a second curved surface configured in a such a manner that light incident from the first curved surface emerges in a uniform diffuse transmission manner. In one solution of the present invention, the light incident surface is the first curved surface that defines the cavity opening to the light source for enabling light from the light source to be incident at different incident angles in different positions of the first curved surface as much as is possible; and the second curved surface is configured in such a manner that emergent light further emerges in a uniform diffuse transmission manner. As a plurality of microlenses having good diffuse effects are combined into an integral lens in an array form, a uniform diffuse effect can be achieved and an ideal light distribution pattern can be obtained. According to the present invention, the first curved surface is a rotationally symmetrical curved surface, and comprises, viewed in a longitudinal direction of respective microlens, a first sub-region in a center and second sub-regions located at both sides of the first sub-region. Thus, the first curved surface having the first sub-region and the second sub-regions define a cavity opening to the light source. A rotationally symmetrical cavity can widely receive light from the light source and assure the light to be uniformly and symmetrically refracted in the microlenses. According to the present invention, the first sub-region is spherical. By means of the spherical first sub-region, brightness of a light spot, in the center and at sides, generated by light from the light source after emerging from the lens is nearly uniform, and a brighter region will not be formed in the center of the light spot, thus a uniform light distribution is obtained. According to the present invention, the second sub-region is conical, as a result, light from the light source can directly go into the microlenses, which avoids a light loss caused by several times of refraction on smooth side walls.

In a preferred solution of the present invention, profiles of the first curved surface and the second curved surface are designed according to a beam angle of an expected light distribution pattern to be generated by the light emerging from the microlenses. According to application requirements, the profiles of the first curved surface and the second curved surface can be correspondingly adjusted according to beam angles of light distribution patterns in order to obtain different expected light distribution patterns, thus adjusting the beam angles.

In a preferred solution of the present invention, viewed in a longitudinal direction of respective microlens, the second curved surface comprises a central region having a concave profile and side regions having a convex profile and located at both sides of the central region, and the central region and the side regions are in a smooth transition. The light emergent surface is designed to be such second curved surface so that a uniform light distribution is further obtained.

In a preferred solution of the present invention, the second curved surface is a rotationally symmetrical curved surface. A rotationally symmetrical design can assure light to uniformly and symmetrically emerge through the curved surface. Besides, such rotationally symmetrical curved surface is also easily fabricated.

In a preferred solution of the present invention, a profile curve of the second curved surface on a symmetrical longitudinal section can be defined by an equation y = 0.0171x⁴ - 0.132x³ + 0.0667x² - 0.1225x + 4.3336.

In a preferred solution of the present invention, a profile curve of the first curved surface on a symmetrical longitudinal section can be defined by an equation y = -0.004x⁶ + 0.0634x⁵ - 0.3759x⁴ + 1.0004x³ - 1.2068x² + 0.6735x + 3.9442.

In a preferred solution of the present invention, the base and the microlens array are formed in one piece. For instance, the microlens array can be formed directly on the base by means of injection molding, die casting or other manners, consequently, the fabrication is easy and material consistency is guaranteed.

Preferably, the lens is made from PC. The lens also can be made from PMMA and other suitable materials.

The other object of the present invention is accomplished via an illuminating device with such type of lens. This illuminating device can produce a uniform light distribution.

According to a preferred solution of the present invention, a light source of the illuminating device is an LED source. The LED source as a green energy source is featured by a long service life and a high optical efficiency.

### Brief Description of the Drawings

The accompanying drawings constitute a part of the present Description and are used to provide further understanding of the present invention. Such accompanying drawings illustrate the embodiments of the present invention and are used to describe the principles of the present invention together with the Description. In the accompanying drawings the same components are represented by the same reference numbers. As shown in the drawings:
Fig. 1 is a sectional view of a lens of the present invention;
Fig. 2 is an enlarged local view of a lens of the present invention, wherein a sectional view of a microlens of a first embodiment is shown;
Fig. 3 is a light distribution pattern of the microlens of the first embodiment in Fig. 2;
Fig. 4 is a sectional view of a microlens of a second embodiment;
Fig. 5 is a light distribution pattern of the microlens of the second embodiment in Fig. 4;
Fig. 6 is an illuminating device of the present invention; and
Fig. 7 shows light distribution curves of an illuminating device of the present invention.

### Detailed Description of the Embodiments

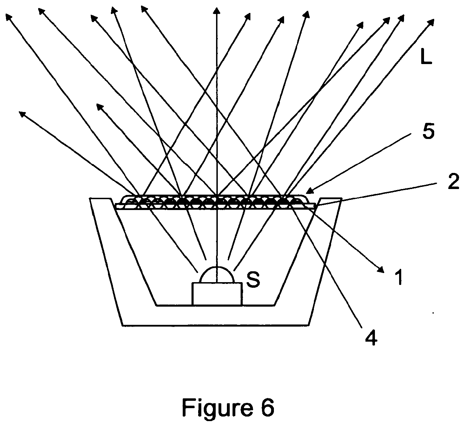

Fig. 1 is a sectional view of a lens of the present invention. As can be seen from Fig. 1, the lens 1 comprises a base 2 and a microlens array formed on the base 2 in one piece, wherein the microlens array consists of a plurality of microlenses 3 that are preferably uniformly arranged. The microlens 3 has a first curved surface 4 as a light incident surface 4 and a second curved surface 5 as a light emergent surface 5. In order to uniformly diffuse light L (see Fig. 6) from a light source S (see Fig. 6) through the lens 1, the first curved surface 4 and the second curved surface 5 are specially designed to be different curved surfaces, wherein the first curved surface 4 defines a cavity R opening to the light source S and the second curved surface 5 is a non-spherical curved surface.

It can be further seen from Fig. 1 that respective microlens 3 is rotationally symmetrical in relation to its own central axis, that is to say, the first curved surface 4 and the second curved surface 5 preferably are also rotationally symmetrical curved surfaces.

Fig. 2 is an enlarged local view of a lens of the present invention, wherein a sectional view of a microlens of a first embodiment is shown. In this embodiment, the second curved surface 5 of the microlens 3 has a central region 5a having a concave profile and side regions 5b each having a convex profile and located at both sides of the central region 5a, and the central region 5a and the side regions 5b are in a smooth transition. A profile curve of the second curved surface 5 on a symmetrical longitudinal section can be defined by an equation y = 0.0171x⁴ - 0.132x³ + 0.0667x² - 0.1225x + 4.3336.

The first curved surface 4 of the microlens 3 comprises a first sub-region 4a in a center and second sub-regions 4b at both sides of the first sub-region 4a, wherein the first sub-region 4a is spherical, the second sub-regions 4b are smoothly conical, and the first sub-region 4a and the second sub-regions 4b are in a smooth transition. A profile curve of the first curved surface 4 on a symmetrical longitudinal section can be defined by an equation y = -0.004x⁶ + 0.0634x⁵ - 0.3759x⁴ + 1.0004x³ - 1.2068x² + 0.6735x + 3.9442.

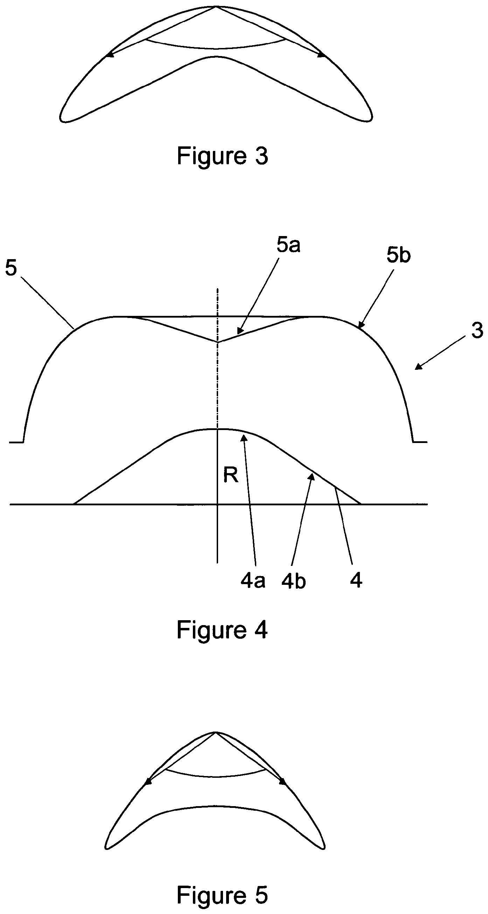

A height of the cavity R defined by the first curved surface 4 is bigger than a distance between the central region 5a and the first sub-region 4a. The microlens 3 having such profile can better diffuse light, so that light is more uniformly distributed. In conjunction with Fig. 3, it can be seen that the light distribution pattern obtained has a big beam angle.

Fig. 4 is a sectional view of a microlens of a second embodiment, which is different from the first embodiment shown in Fig. 2 in that Fig. 4 shows a microlens 3 that has slight changes in shape and profile by changing the first curved surface 4 and the second curved surface 5. In this embodiment, the first sub-region 4a has a smaller size, and the second sub-region 4b has a bigger inclined angle with respect to the central axis, thus, the height of the cavity R defined is smaller than the height of the cavity R in the first embodiment. The central region 5a of the second curved surface 5 has bigger area and depth, compared with the first embodiment, so that a light distribution pattern shown in Fig. 5 different from that shown in Fig. 3 is obtained. With reference to the light distribution pattern shown in Fig. 5, it can be seen that a beam angle that can be realized by the microlens 3 having the slightly changed shape is smaller than the beam angle shown in Fig. 3.

Fig. 6 is an illuminating device of the present invention, wherein the illuminating device comprises the lens 1 as mentioned above. The light source S and the lens 1 are arranged with the same center axes, so that emergent light L can uniformly pass through the first curved surface 4 and the second curved surface 5 of the lens 1, favorable for obtaining a uniform light distribution pattern. In this illuminating device, the light source S can be an LED, and the lens 1 can be made from PC or other suitable materials.

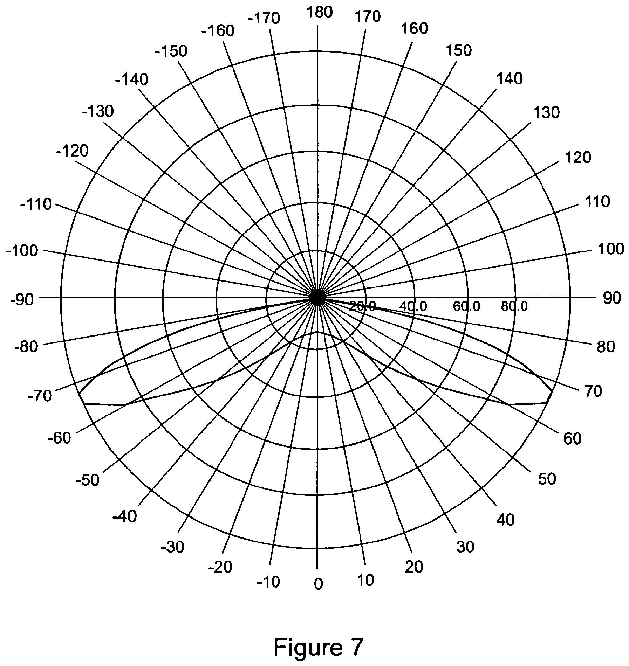

Fig. 7 shows light distribution curves of an illuminating device of the present invention. It can be seen clearly from Fig. 7 that the curves of light intensity and light distribution of the illuminating device of the present invention are uniformly symmetrical.

Besides, upon simulated calculation, the lens of the present invention can make emergent light have a uniformity of up to 95%, a flux output of up to 84.29lm and an optical efficiency of up to 84.29%, when the light source input of the illuminating device is 100lm.

The above is merely preferred embodiments of the present invention but not to limit the present invention. For the person skilled in the art, the present invention may have various alterations and changes. The scope of the invention is defined by the claims.

### List of reference signs

- 1: lens
- 2: base
- 3: microlens
- 4: light incident surface/first curved surface
- 4a: first sub-region
- 4a: second sub-region
- 5: light emergent surface/second curved surface
- 5a: central region
- 5b: side region
- L: light
- R: cavity
- S: light source

## Claims

1. A lens (1), for an illuminating device, comprising a base (2) and a microlens array arranged on the base (2), wherein the microlens array comprises a plurality of microlenses (3), respective microlens (3) has a light incident surface (4) facing a light source (S) of the illuminating device and a light emergent surface (5) facing away from the light source (S), **characterized in that** the light incident surface (4) is a first curved surface (4) that defines a cavity (R) opening to the light source (S), and the light emergent surface (5) is a second curved surface (5) configured in a such a manner that light (L) incident through the first curved surface (4) emerges in a uniform diffuse transmission manner., wherein, the first curved surface (4) is a rotationally symmetrical curved surface, and comprises, viewed in a longitudinal direction of respective microlens (3), a first sub-region (4a) in a center and second sub-regions (4b) located at both sides of the first sub-region (4a), wherein, the first sub-region (4a) is spherical and the second sub-region (4b) is conical.

2. The lens (1) according to Claim 1, **characterized in that** profiles of the first curved surface (4) and the second curved surface (5) are designed according to a beam angle of an expected light distribution pattern generated by the light (L) emerging from the microlenses (3).

3. The lens (1) according to Claim 2, **characterized in that**, viewed in a longitudinal direction of respective microlens (3), the second curved surface (5) comprises a central region (5a) having a concave profile and side regions (5b) having a convex profile and located at both sides of the central region (5a), and the central region (5a) and the side regions (5b) are in a smooth transition.

4. The lens (1) according to Claim 3, **characterized in that** the second curved surface (5) is a rotationally symmetrical curved surface.

5. The lens (1) according to Claim 3, **characterized in that** a profile curve of the second curved surface (5) on a symmetrical longitudinal section can be defined by an equation y = 0.0171x⁴ - 0.132x³ + 0.0667x² - 0.1225x + 4.3336.

6. The lens (1) according to Claim 1, **characterized in that** a profile curve of the first curved surface (4) on a symmetrical longitudinal section can be defined by an equation y = -0.004x⁶ + 0.0634x⁵ - 0.3759x⁴ + 1.0004x³ - 1.2068x² + 0.6735x + 3.9442.

7. The lens (1) according to any one of Claims 1-6, **characterized in that** the base (2) and the microlens array are formed in one piece.

8. The lens (1) according to any one of Claims 1-6, **characterized in that** the lens (1) is made from PC.

9. An illuminating device, **characterized in that** the illuminating device comprises the lens (1) according to any one of Claims 1-8.

## Patentansprüche

1. Linse (1) für eine Beleuchtungsvorrichtung, umfassend eine Basis (2) und eine Mikrolinsenanordnung, die auf der Basis (2) angeordnet ist, wobei die Mikrolinsenanordnung mehrere Mikrolinsen (3) umfasst, wobei eine jeweilige Mikrolinse (3) eine Lichteinfallfläche (4), die einer Lichtquelle (S) der Beleuchtungsvorrichtung zugewandt ist, und eine Lichtausfallfläche (5), die von der Lichtquelle (S) abgewandt ist, aufweist, **dadurch gekennzeichnet, dass** die Lichteinfallfläche (4) eine erste gekrümmte Fläche (4) ist, die einen Hohlraum (R) definiert, welcher sich zur Lichtquelle (S) hin öffnet, und die Lichtausfallfläche (5) eine zweite gekrümmte Fläche (5) ist, die derart ausgelegt ist, dass Licht (L), welches durch die erste gekrümmte Fläche (4) einfällt, in einer gleichmäßig diffusen Übertragungsweise austritt, wobei die erste gekrümmte Fläche (4) eine rotationssymmetrische, gekrümmte Fläche ist und, in Längsrichtung der jeweiligen Mikrolinse (3) betrachtet, einen ersten Teilbereich (4a) in einer Mitte und zweite Teilbereiche (4b) an beiden Seiten des ersten Teilbereichs (4a) umfasst, wobei der erste Teilbereich (4a) sphärisch ist und der zweite Teilbereich (4b) konisch ist.

2. Linse (1) gemäß Anspruch 1, **dadurch gekennzeichnet, dass** Profile der ersten gekrümmten Fläche (4) und der zweiten gekrümmten Fläche (5) gemäß einem Strahlwinkel eines erwarteten Lichtverteilungsmusters, welches durch das Licht (L) erzeugt wird, das aus den Mikrolinsen (3) austritt, konzipiert sind.

3. Linse (1) gemäß Anspruch 2, **dadurch gekennzeichnet, dass**, in Längsrichtung der jeweiligen Mikrolinse (3) betrachtet, die zweite gekrümmte Fläche (5) einen Mittenbereich (5a), der ein konkaves Profil aufweist, und Seitenbereiche (5b), die ein konvexes Profil aufweisen und an beiden Seiten des Mittenbereichs (5a) angeordnet sind, umfasst, und dass der Mittenbereich (5a) und die Seitenbereiche (5b) einen nahtlosen Übergang bilden.

4. Linse (1) gemäß Anspruch 3, **dadurch gekennzeichnet, dass** die zweite gekrümmte Fläche (5) eine rotationssymmetrische, gekrümmte Fläche ist.

5. Linse (1) gemäß Anspruch 3, **dadurch gekennzeichnet, dass** eine Profilkrümmung der zweiten gekrümmten Fläche (5) in einem symmetrischen Längsabschnitt durch eine Gleichung y = 0,0171x⁴ - 0,132x³ + 0,0667x² - 0,1225x + 4,3336 definiert sein kann.

6. Linse (1) gemäß Anspruch 1, **dadurch gekennzeichnet, dass** eine Profilkrümmung der ersten gekrümmten Fläche (4) in einem symmetrischen Längsabschnitt durch eine Gleichung y = -0,004x⁶ + 0,0634x⁵ - 0,3759x⁴ + 1,0004x³ - 1,2068x² + 0,6735x + 3,9442 definiert sein kann.

7. Linse (1) gemäß einem der Ansprüche 1-6, **dadurch gekennzeichnet, dass** die Basis (2) und die Mikrolinsenanordnung einstückig ausgebildet sind.

8. Linse (1) gemäß einem der Ansprüche 1-6, **dadurch gekennzeichnet, dass** die Linse (1) aus PC gefertigt ist.

9. Beleuchtungsvorrichtung, **dadurch gekennzeichnet, dass** die Beleuchtungsvorrichtung die Linse (1) gemäß einem der Ansprüche 1-8 umfasst.

## Revendications

1. Une lentille (1), destinée à un dispositif d'éclairage, comprenant une base (2) et une matrice de microlentilles agencée sur la base (2), la matrice de microlentilles comprenant une pluralité de microlentilles (3), chaque microlentille respective (3) possédant une surface d'incidence de lumière (4) tournée vers une source de lumière (S) du dispositif d'éclairage et une surface d'émergence de lumière (5) tournée à l'opposé de la source de lumière (S), **caractérisée en ce que** la surface d'incidence de lumière (4) est une première surface incurvée (4) qui définit une cavité (R) s'ouvrant sur la source de lumière (S), et la surface d'émergence de lumière (5) est une deuxième surface incurvée (5) configurée de telle manière qu'une lumière (L) incidente au travers de la première surface incurvée (4) émerge d'une manière à transmission diffuse uniforme, la première surface incurvée (4) étant une surface incurvée symétrique en rotation, et comprend, vue dans une direction longitudinale de chaque microlentille respective (3), une première sous-zone (4a) dans un centre et des deuxièmes sous-zones (4b) placées sur les deux cotés de la première sous-zone (4a), la première sous-zone (4a) étant sphérique et la deuxième sous-zone (4b) étant conique.

2. La lentille (1) selon la revendication 1, **caractérisée en ce que** des profils de la première surface incurvée (4) et de la deuxième surface incurvée (5) sont conçus en fonction d'un angle de faisceau d'un motif de distribution de lumière attendu généré par la lumière (L) émergeant des microlentilles (3) .

3. La lentille (1) selon la revendication 2, **caractérisée en ce que**, vue dans une direction longitudinale de chaque microlentille respective (3), la deuxième surface incurvée (5) comprend une zone centrale (5a) possédant un profil concave et des zones latérales (5b) possédant un profil convexe et placées sur les deux cotés de la zone centrale (5a), et la zone centrale (5a) et les zones latérales (5b) sont dans une transition douce.

4. La lentille (1) selon la revendication 3, **caractérisée en ce que** la deuxième surface incurvée (5) est une surface incurvée symétrique en rotation.

5. La lentille (1) selon la revendication 3, **caractérisée en ce qu'**une courbe de profil de la deuxième surface incurvée (5) sur une section longitudinale symétrique peut être définie par une équation y = 0,0171x⁴ - 0,132x³ + 0,0667x² - 0,1225x + 4,3336.

6. La lentille (1) selon la revendication 1, **caractérisée en ce qu'**une courbe de profil de la première surface incurvée (4) sur une section longitudinale symétrique peut être définie par une équation y = -0,004x⁶ + 0,0634x⁵ - 0,3759x⁴ + 1,0004x³ - 1,2068x² + 0,6735x + 3,9442.

7. La lentille (1) selon l'une quelconque des revendications 1 à 6, **caractérisée en ce que** la base (2) et la matrice de microlentilles sont formées d'un seul tenant.

8. La lentille (1) selon l'une quelconque des revendications 1 à 6, **caractérisée en ce que** la lentille (1) est composée de PC.

9. Un dispositif d'éclairage, **caractérisé en ce que** le dispositif d'éclairage comprend la lentille (1) selon l'une quelconque des revendications 1 à 8.
